# EUROPÄISCHE PATENTSCHRIFT

(11) **EP 3 310 139 B1**
(45) Veröffentlichungstag und Bekanntmachung des Hinweises auf die Patenterteilung: **04.09.2019**
(21) Anmeldenummer: 16193230.6
(22) Anmeldetag: 11.10.2016
(51) Int. Cl.: H05K 7/20

(54) **BAUGRUPPENTRÄGER**
MODULE HOLDER
CHÂSSIS

(43) Veröffentlichungstag der Anmeldung: 18.04.2018
(73) Patentinhaber: Pentair Technical Solutions GmbH, 75334 Straubenhardt (DE)
(72) Erfinder: Mann, Dietmar, 75196 Remchingen (DE); Kistner, Oliver, 75177 Pforzheim (DE); Euchner, Heinz, 75217 Birkenfeld (DE)
(74) Vertreter: Grünecker Patent- und Rechtsanwälte PartG mbB

(56) Entgegenhaltungen:
- US-A1- 2013 309 957
- US-A1- 2016 183 413
- US-B1- 6 563 706
- US-B2- 8 514 571

## Beschreibung

Die Erfindung betrifft einen Baugruppenträger zum Einbau von Elektronikkarten mit standardisiertem Platinenformat, beispielsweise nach dem PICMG-Standard "Advanced Telecom Computing Architecture (ATCA)" für leistungsfähige Kommunikationsserver. Es handelt sich hierbei um eine skalierbare leistungsfähige Architektur, die sich durch eine hohe Funktionsdichte bei geringem Platzbedarf auszeichnet.

Wird eine größere Anzahl von Platinen mit vielen elektronischen Komponenten oder Modulen in einen relativ kleinen Baugruppenträger gepackt, kommt dem Wärme-Management besondere Bedeutung zu, da entsprechend viel Verlustwärme von den Elektronikplatinen abgeführt werden muss. Nach der Spezifikation PICMG 3.0 sind bis zu 450 Watt pro ATCA-Board zulässig, was bei einem Baugruppenträger mit 14 Einbauplätzen (slots) einer abzuführenden Wärme von über 6 Kilowatt entspricht.

Zu einem ATCA-Baugruppenträger gehören elektrische Lüfter, die sich unterhalb oder oberhalb des Einbauraums befinden. Kühle Luft aus der Umgebung wird dabei durch Öffnungen an der Gehäusefront angesaugt und in den Einbauraum geleitet, wo sie an den Elektronikplatinen vorbei streicht, um diese zu kühlen. Die erwärmte Abluft wird anschließend durch Öffnungen an der Rückseite des Gehäuses ausgeblasen. Die elektrischen Lüfter werden üblicherweise zu einem horizontalen Lüftereinschub zusammengefasst, welcher zu Wartungs- und Reparaturzwecken aus dem Gehäuse herausgezogen werden kann.

Es ist klar, dass eine leistungsfähige Lüftung einschließlich der zugehörigen Luftverteilräume relativ viel Platz im Baugruppenträger beansprucht. Dies begrenzt den für den Einbau von Elektronikplatinen verbleibenden Einbauraum, insbesondere die aktiv nutzbare Höhe.

Die eine Anzahl von Elektronikplatinen und die zur Kühlung erforderlichen Lüfter bzw. Lüftereinschübe umfassenden Serversysteme werden mittels separaten Unterbaugruppen oder Einschüben mit elektrischer Energie versorgt. Die Power-Units (PSU) versorgen das Gesamtsystem mit Strom, wobei die Betriebsspannungen laufend gemessen und überwacht werden, in Kooperation mit einem oder mehreren Shelf-Managern. Die Stromversorgungseinheiten, die bei größeren Systemen auch gerne doppelt oder mehrfach redundant ausgeführt werden, benötigen weiteren Platz, insbesondere Höhe, welche wiederum nicht als Einbauraum für Elektronikkarten zur Verfügung steht.

US 8,514,571 B2 beschreibt einen Baugruppenträger für horizontalen Einbau von Elektronikkarten (horizontal sub-rack). Über und unter einem Einbauraum für Leiterplatten ist eine Lüftungsbox angeordnet. Diese Box wird durch eine Trennwand in eine rechte und eine linke Kammer geteilt, nämlich eine Lufteintritts-Kammer für kühle Zuluft und eine Luftaustritts-Kammer für erwärmte Abluft. An der Vorderseite ist ein Lufteintritt für kalte Zuluft, an der Rückseite ein Luftaustritt für die erwärmte Abluft vorgesehen. Hinter dem Lufteintritt sitzt eine Lüftereinheit mit mehreren elektrischen Ventilatoren. Rechts und links des Einbauraums sind Lufträume vorgesehen, nämlich ein Luftverteilraum für einströmende Kaltluft und ein Luftsammelraum für erwärmte Luft. Diese Lufträume stehen mit der Einlasskammer bzw. der Auslasskammer der Lüftungsbox In Verbindung. Somit kann Frischluft aus der Umgebung durch den Einlass angesaugt und nach unten In den Luftverteilraum gedrückt werden ("push").Die Kaltluft wird um 90 Grad In die Horizontale gelenkt, strömt durch den Einbauraum hindurch und sammelt sich als erwärmte Luft In dem Luftsammelraum auf der anderen Seite. Von dort wird die Warmluft nach oben In die Luftauslass-Kammer gedrückt und entweicht schließlich durch den Luft-

US 6 563 706 B1 beschreibt ein Stromversorgungsmodul für eine Stromschiene (power bus). Dabei sind auf einem Stromversorgungsmodul jeweils eine Stromquelle und mindestens ein Lüfter zur Kühlung der Stromquelle angebracht. Die Lüfter werden mit Spannung von der Stromschiene versorgt.

Das zu lösende technische Problem besteht In dem Zielkonflikt, in einem Baugruppenträger vorgegebener Größe, Insbesondere mit einer bestimmten standardisierten Höhe, einen möglichst großen Einbauraum für Elektronikkarten zur Verfügung zu stellen, gleichzeitig aber auch eine ausreichende Anzahl von elektrischen Lüftern für eine wirksame Kühlung sowie die notwendige Stromversorgung für das Gesamtsystem unterzubringen.

Bei der Lösung dieser Aufgabe wird ausgegangen von einem Baugruppenträger gemäß dem Oberbegriff des ersten Patentanspruchs. Gelöst wird die Aufgabe gemäß dem kennzeichnenden Teil des Patentanspruchs 1 dadurch, dass der Lüftereinschub nicht nur elektrische Lüfter enthält, sondern auch mindestens eine Stromversorgungseinheit als integrierten Bestandteil. Die für den Lüftereinschub ohnehin "verlorene" Höhe wird also erfindungsgemäß benutzt für die Unterbringung einer Stromversorgungseinheit, die ansonsten zusätzlichen Einbauraum kosten würde. Die Gesamthöhe des komplett mit Elektronikkarten, Lüftern und Stromversorgung bestückten Baugruppenträgers wird erheblich reduziert, mindestens um die Höhe einer Stromversorgungseinheit.

Da erfindungsgemäß die Lüftereinheit als tauschbarer Einschub in der Art einer Schublade ausgebildet ist, ist die notwendige Zugänglichkeit zu der integrierten Stromversorgungseinheit jederzeit gewährleistet Bei einem Defekt oder zu Wartungszwecken kann einfach der Lüftereinschub mit der integrierten PSU aus dem Gehäuse herausgezogen werden, um an die Stromversorgungseinheit zu gelangen.

Um die Lufteinlassöffnungen und die Luftauslassöffnungen auf gleicher Höhe anzuordnen, muss das Gehäusefach, das den Lüftereinschub aufnimmt, in eine Lufteingangskammer für kalte Zuluft und eine Luftausgangskammer für erwärmte Abluft geteilt werden. Dies erfolgt vorzugsweise dadurch, dass der Lüftereinschub eine Rückwand hat, die als Raumteiler bzw. Trennelement dient.

Besonders vorteilhaft hat der Lüftereinschub einen Grundriss in Form eines rechtwinkligen Dreiecks, dessen Hypotenuse durch die Rückwand gebildet wird. Es entstehen dadurch annähernd dreieckige und etwa gleichgroße Kammern für Lufteingang und Luftausgang.

Die in den Lüftereinschub integrierte Stromversorgungseinheit ist vorzugsweise in der Lufteingangskammer angeordnet, so dass sie im Strom der kalten Zuluft liegt. Besonders vorteilhaft ist die Anordnung der Stromversorgungseinheit im Bereich der Rückwand des Lüftereinschubs, da sie dort den Kühlluftstrom kaum behindert. Sofern die Stromversorgungseinheit ein Gehäuse in Form eines schmalen rechteckigen Quaders hat, ist es zweckmäßig, die Stromversorgungseinheit mit einer Längsseite parallel zur Rückwand des Lüftereinschubs anzuordnen. Besonders vorteilhaft ist es, wenn das Gehäuse der Stromversorgungseinheit an der Rückwand des Lüftereinschubs befestigt ist. Die Stromversorgungseinheit bildet dann einen Teil der Luftführung für die Kühlluft bzw. ein integrierter Bestandteil des Trennelements zwischen Lufteingangskammer und Luftausgangskammer.

Die Stromversorgungseinheit hat üblicherweise selbst einen kleinen elektrischen Lüfter, der in das Gehäuse eingebaut ist. Wenn nun die Stromversorgungseinheit erfindungsgemäß integrierter Bestandteil des Lüftereinschubs ist, so ist es zweckmäßig, die Stromversorgungseinheit so anzuordnen, dass der Luftstrom des eingebauten elektrischen Lüfters parallel zum Hauptluftstrom der in die Lufteingangskammer einströmenden Kühlluft verläuft. Haupt- und Nebenluftstrom sind dann gleichgerichtet und ergänzen bzw. verstärken sich dadurch. Sollte es zum Ausfall eines oder gar aller Lüfter des Lüftereinschubs kommen, so bleibt die davon unabhängige Eigenkühlung der Stromversorgung erhalten und kann, bis zu einem gewissen Grad, als Notkühlung für die Elektronikplatinen dienen. Umgekehrt würde auch ein Ausfall der Eigenkühlung der Stromversorgung durch den Kühlluftstrom durch die Lufteingangskammer zumindest teilweise kompensiert werden, was die Ausfallsicherheit erhöht.

Bei höheren Baugruppenträgern mit einem Einbauraum für eine größere Anzahl von Elektronikplatinen können Lüftereinschübe mit integrierten Stromversorgungseinheiten sowohl über als auch unterhalb des Einbauraums für Elektronikkarten vorgesehen werden. Dabei liegen die Lufteinlassöffnungen der beiden Lüftereinschübe zweckmäßigerweise auf derselben Seite, üblicherweise an der Vorderseite des Baugruppenträgers. Entsprechend blasen dann beide Lüftereinschübe die erwärmte Abluft an der gegenüberliegenden Seite des Baugruppenträgers, also an der Rückseite, aus.

Ein Ausführungsbeispiel der Erfindung wird nachstehend anhand der beigefügten Abbildungen näher beschrieben. Es zeigen:
- Figur 1: einen Baugruppenträger mit zwei herausgezogenen Lüftereinschüben, in perspektivischer Ansicht von hinten;
- Figur 2a: einen Lüftereinschub aus Figur 1 mit integrierter Stromversorgungseinheit, in größerem Maßstab;
- Figur 2b: den Lüftereinschub von Figur 2a ohne Deckblech;
- Figur 3a: den Baugruppenträger von Figur 1 mit eingesetzten Lüftereinschüben, teilweise geöffnet, in perspektivischer Ansicht von links;
- Figur 3b: den Baugruppenträger gemäß Figur 3a, in perspektivischer Ansicht von rechts.

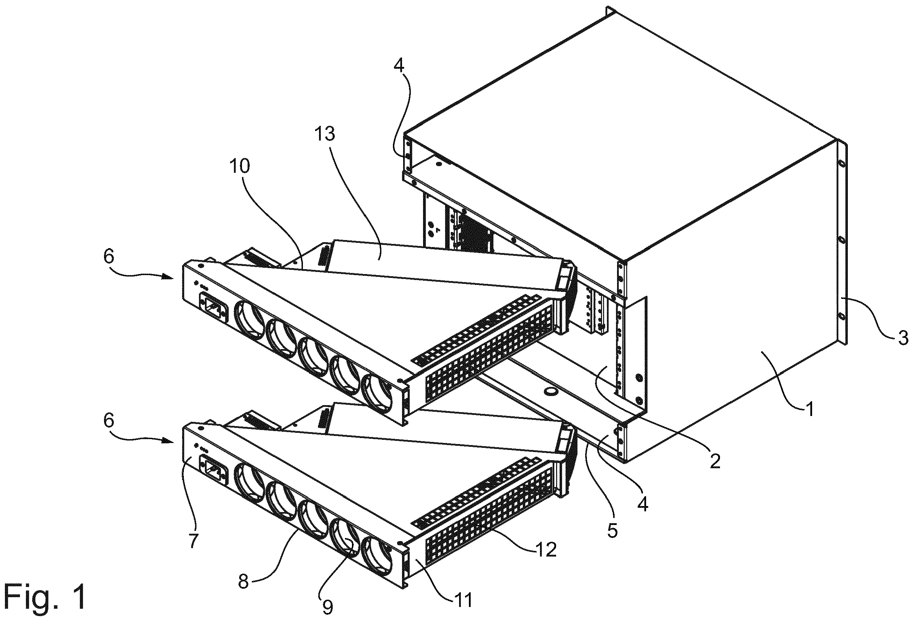

Bei dem in Figur 1 dargestellten Baugruppenträger handelt es sich um ein Advanced TCA-System mit einem Gehäuse 1, das einen Einbauraum 2 für standardisierte Elektronikplatinen allseitig umgibt. Spiegelbildlich nach außen weisende Befestigungsflansche 3 an der Vorderseite des Gehäuses 1 dienen dem Einbau in ein 19-Zoll-Gestell oder in ein 23-Zoll-Telecom-Shelf. Die (hier nicht dargestellten) Karten oder Platinen mit den aktiven elektronischen Bauelementen werden horizontal in den Einbauraum 2 eingeschoben; es handelt sich hier also um ein "horizontal sub-rack".

Oberhalb und unterhalb des Einbauraums 2 ist jeweils ein Fach 4 angeordnet. Die horizontalen Fachböden 5 dieser Fächer 4 begrenzen den Einbauraum 2 nach oben bzw. unten. Boden und Deckel des Gehäuses 1 schließen die Fächer 4 nach unten bzw. nach oben hin ab. Zur Rückseite des Gehäuses 1 hin sind die Fächer 4 offen.

In die offenen Fächer 4 kann jeweils ein Lüftereinschub 6 eingeschoben werden. In Figur 1 sind die beiden Lüftereinschübe 6 herausgezogen. In eingeschobenem Zustand sitzen die Lüftereinschübe 6 in den Fächern 4, wobei die Frontseiten 7 der Lüftereinschübe 6 mit der Rückseite des Gehäuses 1 bündig abschließen. In den Frontseiten 7 der Lüftereinschübe 6 sind jeweils fünf Luftauslassöffnungen 8 angeordnet, hinter denen sich jeweils ein elektrischer Lüfter 9 befindet.

Die Lüftereinschübe 6 sind als im Wesentlichen geschlossene Kassetten aus Blech ausgebildet und haben einen Grundriss in Form eines rechtwinkligen Dreiecks. Die Hypotenuse dieses Dreiecks wird von der Rückwand 10 des Lüftereinschubs 6 gebildet. Die Seitenwände 11 haben große rechteckige Lufteinlässe 12, durch die Kühlluft in den Einbauraum 2 einströmen kann.

An den Außenseiten der Rückwände 10 der Lüftereinschübe 6 ist jeweils eine Stromversorgungseinheit 13 befestigt. Die Stromversorgungseinheit 13 hat ein Gehäuse in Form eines schmalen rechteckigen Quaders und erstreckt sich mit ihrer Längsseite parallel zur Rückwand 10 des zugehörigen Lüftereinschubs 6.

Somit bildet die Stromversorgungseinheit 13 einen integralen Bestandteil des zugehörigen Lüftereinschubs 6.

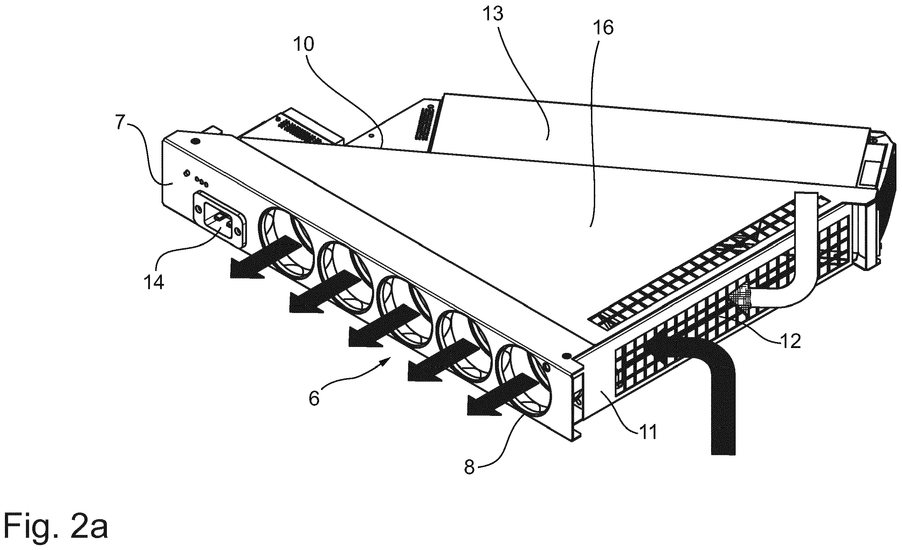

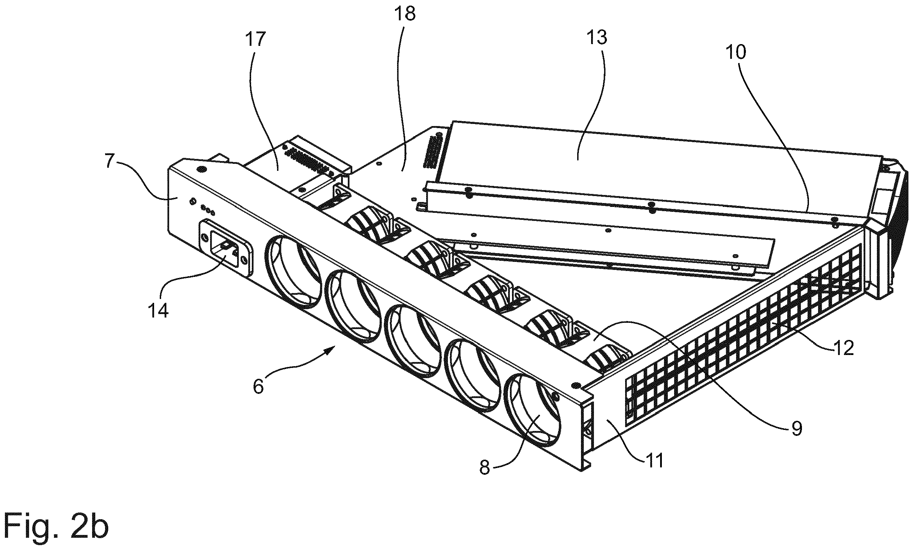

Die Figuren 2a und 2b lassen weitere Details der Lüftereinschübe 6 mit angebauter Stromversorgungseinheit 13 erkennen. In Figur 2b ist das dreieckige Deckblech 16 des Lüftereinschubs 6 abgenommen. Dadurch wird der Blick in das Innere frei.

An der Frontseite 7 ist neben den runden Luftauslassöffnungen 8 ein Netzanschluss 14 angeordnet. Die jeweils hinter den Luftauslassöffnungen 8 angeordneten Lüfter 9 sind Axiallüfter, welche an ihrer Rückseite einen Unterdruck erzeugen, die kalte Zuluft durch den Einbauraum 2 ziehen ("pull") und die erwärmte Abluft durch die Luftauslassöffnungen 8 in die Umgebung blasen.

Hinter dem Netzanschluss 14 sitzt eine kompakte elektronische Steuereinheit 17. Im Bereich vor der Rückwand 10 sitzt eine Steuerungsplatine 18, die weitere elektronische Module zur Regelung und Überwachung des Systems enthält.

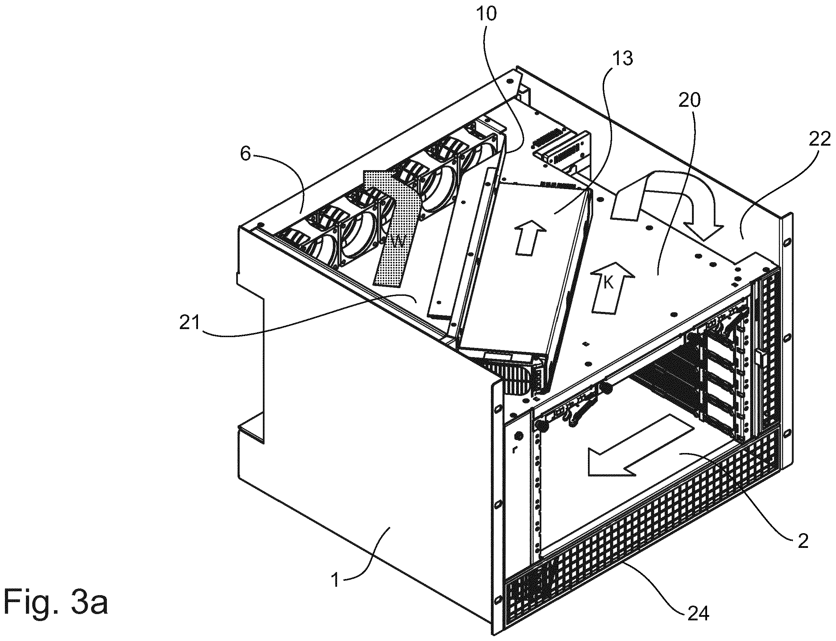

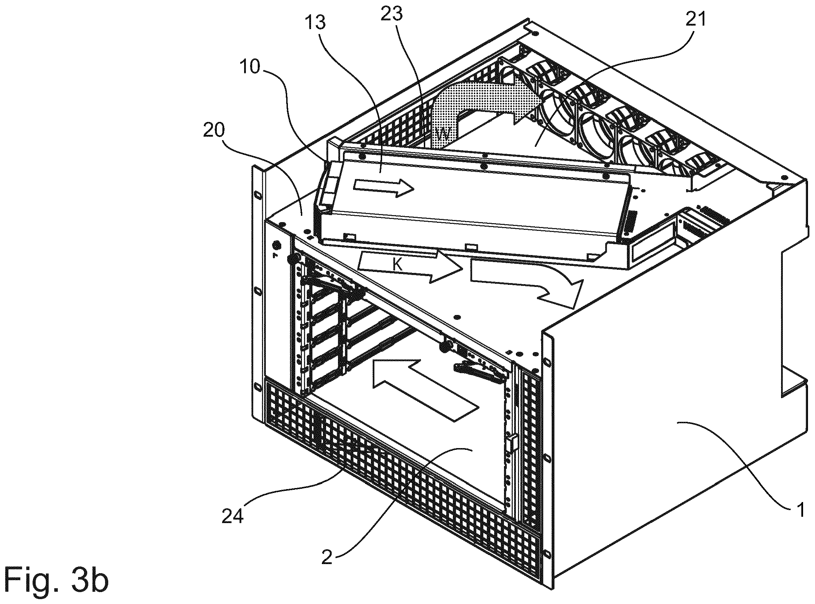

In den Abbildungen der Figuren 3a und 3b sind die Lüftereinschübe 6 in die Fächer 4 des Gehäuses 1 eingeschoben. Jetzt wird erkennbar, wie die angesaugte Kühlluft durch das Innere des Gehäuses 1 strömt, um die Abwärme aus dem Einbauraum 2 wirksam abzuleiten.

Die Rückwand 10 des Lüftereinschubs mit anmontierter Stromversorgungseinheit 13 dient als praktisch luftdichtes Trennelement zwischen einer Lufteingangskammer 20 und einer Luftausgangskammer 21. Seitlich neben dem Einbauraum 2 liegt ein vertikaler Luftverteilschacht 22, der die Lufteingangskammer 20 mit dem Einbauraum 2 verbindet. An der gegenüberliegenden Seite des Einbauraums 2 ist ein Luftsammelschacht 23 vorgesehen, welcher den Einbauraum 2 mit der Luftausgangskammer 21 verbindet.

Die von den Lüftern 9 des oberen Lüftereinschubs 6 angesaugte Kaltluft K strömt durch (nicht dargestellte) Eingangsöffnungen an der Vorderseite des Gehäuses 1 in die Lufteingangskammer 20. Die Stromversorgungseinheit 13 erstreckt sich parallel zum Hauptluftstrom; deren eingebauter Lüfter erzeugt dabei einen - vergleichsweise kleinen - zweiten Luftstrom, der parallel zum Hauptluftstrom der in die Lufteingangskammer 20 einströmenden Kaltluft K verläuft.

Die eingeströmte Kaltluft K strömt durch den vertikalen Luftverteilschacht 22 nach unten wird nach Umlenkung um 90 Grad in den Einbauraum 2 geleitet, um an den dort eingebauten (nicht dargestellten) Elektronikplatinen vorbei zu streichen. Die dadurch erwärmte Luft wird durch den Luftsammelschacht 23 an der anderen Seite des Einbauraums 2 wieder nach oben geleitet und sammelt sich als warme Abluft W in der Luftausgangskammer 21. Durch die Luftauslassöffnungen 8 an der Rückseite des Gehäuses 1 wird die erwärmte Abluft W ausgeblasen.

Unterhalb des Einbauraums 2 sitzt der zweite Lüftereinschub 6 (vgl. Figur 1) hinter einem Luftgitter 24. Die deshalb hier nicht sichtbare Lufteingangskammer 20 des unteren Lüftereinschubs 6 ist mit demselben Luftverteilschacht 22 verbunden wie die Lufteingangskammer 20 des oberen Lüftereinschubs 6. Die Luftströme beider Lüftereinschübe 6 überlagern sich zu einem gemeinsamen Kühlluftstrom durch den Einbauraum 2.

### Bezugszeichen

- 1: Gehäuse
- 2: Einbauraum
- 3: Befestigungsflansch
- 4: Fach
- 5: Fachboden(von 1)
- 6: Lüftereinschub
- 7: Frontseite (von 6)
- 8: Luftauslassöffnungen (in 7)
- 9: Lüfter
- 10: Rückwand (von 6)
- 11: Seitenwand (von 6)
- 12: Lufteinlass (in 11)
- 13: Stromversorgungseinheit (PSU)
- 14: Netzanschluss
- 16: Deckblech (von 6)
- 17: Steuerungseinheit
- 18: Steuerungsplatine

- 20: Lufteingangskammer
- 21: Luftausgangskammer
- 22: Luftverteilschacht
- 23: Luftsammelschacht
- 24: Luftgitter

- K: Kalte Zuluft
- W: Warme Abluft

## Patentansprüche

1. Baugruppenträger, mit
einem Gehäuse (1), das einen Einbauraum (2) für standardisierte Elektronikplatinen einschließt,
wenigstens einem Lüftereinschub (6), der oberhalb oder unterhalb des Einbauraums (2) angeordnet ist und eine Anzahl von elektrischen Lüftern (9) enthält,
eine Lufteingangskammer (20) für kalte Zuluft (K) sowie eine Luftausgangskammer (21) für erwärmte Abluft (W),
einem seitlich neben dem Einbauraum (2) angeordneten Luftverteilschacht (22), der die Lufteingangskammer (20) mit dem Einbauraum (2) verbindet, um die kalte Zuluft (K) auf die Elektronikplatinen zu leiten,
einem an der gegenüberliegenden Seite des Einbauraums (2) angeordneten Luftsammelschacht (23), der den Einbauraum (2) mit der Luftausgangskammer (21) verbindet, um die erwärmte Abluft (W) abzuführen,
wenigstens einer Stromversorgungseinheit (13), welche die Elektronikplatinen und die Lüfter (9) mit elektrischer Energie versorgt,
**dadurch gekennzeichnet, dass**
der Lüftereinschub (6) in ein Fach (4) des Gehäuses (1) eingeschoben und herausziehbar ist, und
die Stromversorgungseinheit (13) integrierter Bestandteil des Lüftereinschubs (6) ist.

2. Baugruppenträger nach einem der vorhergehenden Ansprüche, **dadurch gekennzeichnet, dass** der Lüftereinschub (6) eine Rückwand (10) hat, welche die Lufteingangskammer (20) von der Luftausgangskammer (21) trennt.

3. Baugruppenträger nach Anspruch 2, **dadurch gekennzeichnet, dass** der Lüftereinschub (6) einen Grundriss hat, der im Wesentlichen der Form eines rechtwinkligen Dreiecks entspricht, wobei die Rückwand (10) die Hypotenuse des Dreiecks bildet.

4. Baugruppenträger nach Anspruch 2 oder 3, **dadurch gekennzeichnet, dass** die Stromversorgungseinheit (13) im Bereich der Rückwand (10) des Lüftereinschubs (6) angeordnet ist.

5. Baugruppenträger nach Anspruch 4, **dadurch gekennzeichnet, dass** das Gehäuse der Stromversorgungseinheit (13) an der Rückwand (10) des Lüftereinschubs (6) befestigt ist.

6. Baugruppenträger nach einem der Ansprüche 2 bis 5, **dadurch gekennzeichnet, dass** die Stromversorgungseinheit (13) ein Gehäuse in Form eines schmalen rechteckigen Quaders hat und mit einer Längsseite parallel zur Rückwand (10) des Lüftereinschubs (6) verläuft.

7. Baugruppenträger nach einem der vorhergehenden Ansprüche, **dadurch gekennzeichnet, dass** die Stromversorgungseinheit (13) in der Lufteingangskammer (20) angeordnet ist, so dass sie im Strom der kalten Zuluft (K) liegt.

8. Baugruppenträger nach Anspruch 7, **dadurch gekennzeichnet, dass** die Stromversorgungseinheit (13) einen eingebauten elektrischen Lüfter hat, dessen Luftstrom parallel zum Hauptluftstrom der in die Lufteingangskammer (21) einströmenden kalten Zuluft (K) verläuft.

9. Baugruppenträger nach einem der vorhergehenden Ansprüche, **dadurch gekennzeichnet, dass** ein erster Lüftereinschub (6) mit integrierter Stromversorgungseinheit (13) über dem Einbauraum (2) angeordnet ist und ein zweiter, im Prinzip gleich ausgebildeter Lüftereinschub (6) mit integrierter Stromversorgungseinheit (13) unterhalb des Einbauraums (2) angeordnet ist, wobei die Luftauslassöffnungen (8) der beiden Lüftereinschübe (6) auf derselben Seite des Gehäuses (1) liegen.

## Claims

1. Module holder comprising
a housing (1) enclosing an installation space (2) for standardized electronic circuit boards,
at least one fan tray (6) which is disposed above or below the installation space (2) and includes one or more electric fans (9),
an air intake chamber (20) for incoming cold air (K) and an air outlet chamber (21) for hot waste air (W),
an air distribution duct (22) which is disposed laterally next to the installation space (2) and which connects the air intake chamber (20) to the installation space (2) to direct the incoming cold air (K) onto the electronic circuit boards,
an air collecting duct (23) which is disposed on the opposite side of the installation space (2) and which connects the installation space (2) to the air outlet chamber (21) to discharge the hot waste air (W),
at least one power supply unit (13) which supplies the electronic circuit boards and the fan (9) with electrical energy,
**characterized in that**
the fan tray (6) is inserted into a compartment (4) of the housing (1) and is extensible, and
the power supply unit (13) is an integral component of the fan tray (6).

2. Module holder according to one of the preceding claims, **characterized in that** the fan tray (6) includes a rear panel (10) that separates the air intake chamber (20) from the air outlet chamber (21).

3. Module holder according to claim 2, **characterized in that** the fan tray (6) has a layout which substantially corresponds to the form of a right-angled triangle, wherein the rear panel (10) forms the hypotenuse of the triangle.

4. Module holder according to claim 2 or 3, **characterized in that** the power supply unit (13) is disposed in the area of the rear panel (10) of the fan tray (6).

5. Module holder according to claim 4, **characterized in that** the housing of the power supply unit (13) is attached to the rear panel (10) of the fan tray (6).

6. Module holder according to one of claims 2 to 5, **characterized in that** the power supply unit (13) includes a housing in the form of a small rectangular block and extends with a longitudinal side in parallel with the rear panel (10) of the fan tray (6).

7. Module holder according to one of the preceding claims, **characterized in that** the power supply unit (13) is disposed within the air intake chamber (20), so that it is positioned within the stream of the incoming cold air (K).

8. Module holder according to claim 7, **characterized in that** the power supply unit (13) includes a built-in electric fan having an air stream extending in parallel with the main air stream of the incoming cold air (K) flowing into the air intake chamber (21).

9. Module holder according to one of the preceding claims, **characterized in that** a first fan tray (6) with integrated power supply unit (13) is disposed above the installation space (2) and a second, in principle identically designed fan tray (6) with integrated power supply unit (13) is disposed below the installation space (2), wherein the air outlet openings (8) of the two fan trays (6) are positioned on the same side of the housing (1).

## Revendications

1. Châssis de support de modules, comprenant
un boitier (1) qui enferme un espace d'implantation (2) pour des platines électroniques standardisées,
au moins un tiroir ou rack de ventilateurs (6), qui est agencé au-dessus ou en-dessous de l'espace d'implantation (2), et renferme un certain nombre de ventilateurs électriques (9),
un compartiment d'entrée d'air (20) pour de l'air d'alimentation froid (K), ainsi qu'un compartiment de sortie d'air (21) pour de l'air d'évacuation échauffé (W),
un puits de distribution d'air (22), qui est agencé latéralement à côté de l'espace d'implantation (2), et relie le compartiment d'entrée d'air (20) à l'espace d'implantation (2), en vue de diriger l'air d'alimentation froid (K) sur les platines électroniques, un puits de collecte d'air (23), qui est agencé sur le côté opposé de l'espace d'implantation (2), et relie l'espace d'implantation (2) au compartiment de sortie d'air (21) pour évacuer l'air d'évacuation échauffé (W), et au moins une unité d'alimentation en courant (13), qui alimente les platines électroniques et les ventilateurs (9) en énergie électrique,
**caractérisé en ce que**
le tiroir ou rack de ventilateurs (6) est inséré dans une alvéole (4) du boitier (1) et peut en être retiré, et
l'unité d'alimentation en courant (13) fait partie intégrante du tiroir de ventilateurs (6).

2. Châssis de support de modules selon l'une des revendications précédentes, **caractérisé en ce que** le tiroir de ventilateurs (6) possède une paroi arrière (10), qui sépare le compartiment d'entrée d'air (20) du compartiment de sortie d'air (21).

3. Châssis de support de modules selon la revendication 2, **caractérisé en ce que** le tiroir de ventilateurs (6) présente un tracé de base, qui correspond sensiblement à la forme d'un triangle rectangle, la paroi arrière (10) formant l'hypoténuse du triangle.

4. Châssis de support de modules selon la revendication 2 ou la revendication 3, **caractérisé en ce que** l'unité d'alimentation en courant (13) est agencée dans la zone de la paroi arrière (10) du tiroir de ventilateurs (6).

5. Châssis de support de modules selon la revendication 4, **caractérisé en ce que** le boitier de l'unité d'alimentation en courant (13) est fixé à la paroi arrière (10) du tiroir de ventilateurs (6).

6. Châssis de support de modules selon l'une des revendications 2 à 5, **caractérisé en ce que** l'unité d'alimentation en courant (13) possède un boitier sous la forme d'un parallélépipède rectangle mince, et s'étend, avec un côté de grande longueur, parallèlement à la paroi arrière (10) du tiroir de ventilateurs (6).

7. Châssis de support de modules selon l'une des revendications précédentes, **caractérisé en ce que** l'unité d'alimentation en courant (13) est agencée dans le compartiment d'entrée d'air (20) de sorte qu'elle se trouve ainsi dans le flux de l'air d'alimentation froid (K) .

8. Châssis de support de modules selon la revendication 7, **caractérisé en ce que** l'unité d'alimentation en courant (13) possède un ventilateur électrique intégré, dont le flux d'air s'étend parallèlement au flux d'air principal de l'air d'alimentation froid (K) entrant dans le compartiment d'entrée d'air (20).

9. Châssis de support de modules selon l'une des revendications précédentes, **caractérisé en ce qu'**un premier tiroir de ventilateurs (6), avec une unité d'alimentation en courant (13) intégrée, est agencé au-dessus de l'espace d'implantation (2), et un deuxième tiroir de ventilateurs (6), en principe de même configuration, avec une unité d'alimentation en courant (13) intégrée, est agencé en-dessous de l'espace d'implantation (2), les ouvertures de sortie d'air (8) des deux tiroirs de ventilateurs (6) étant situées sur le même côté du boitier (1).
